# EUROPEAN PATENT SPECIFICATION

(11) **EP 4 546 953 B1**
(45) Date of publication and mention of the grant of the patent: **22.10.2025**
(21) Application number: 23205106.0
(22) Date of filing: 23.10.2023
(51) Int. Cl.: H05K 3/22, B23K 1/018, H05K 13/04

(54) **A METHOD FOR SELECTIVELY REMOVING ELECTRONIC COMPONENTS FROM PRINTED CIRCUIT BOARDS AND DEVICE FOR CARRYING OUT THIS METHOD**
VERFAHREN ZUM SELEKTIVEN ENTFERNEN VON ELEKTRONISCHEN BAUELEMENTEN VON LEITERPLATTEN UND VORRICHTUNG ZUR DURCHFÜHRUNG DIESES VERFAHRENS
PROCÉDÉ POUR ENLEVER SÉLECTIVEMENT DES COMPOSANTS ÉLECTRONIQUES DE CARTES DE CIRCUITS IMPRIMÉS ET DISPOSITIF POUR LA MISE EN OEUVRE DE CE PROCÉDÉ

(43) Date of publication of application: 30.04.2025
(73) Proprietor: Univerzita Pardubice, Pardubice (CZ)
(72) Inventor: Syrovy, Tomas, Sudlickova Lhota (CZ)
(74) Representative: Sedlák, Jirí

(56) References cited:
- US-A1- 2009 184 407
- US-A1- 2014 021 400
- US-A1- 2016 095 230
- US-A1- 2018 168 032

## Description

### Field of the Invention

The invention relates to the field of electronics recycling, and more particularly to a method for selectively removing electronic components from printed circuit boards and device for carrying out this method.

### Background of the Invention

A printed circuit board or PCB is a base board in electronics designed to be populated with electronic components such as galvanic cells, transistors, resistors, capacitors, inductors, integrated circuits, etc., which are connected by conductors formed in a thin or flat metal layer on the base board surface. The base plate is typically made of a non-conductive material such as fiberglass, composite epoxy, or other laminate material. PCBs are used to implement electronic circuits and can be found in virtually all complex electronic devices.

In recent years, there has been an increase in responsible options and methods to recycle old, partially damaged or discarded printed circuit boards, especially the electronic components thereof that can be reused.

The removal of the electronic components from a printed circuit board for subsequent recycling can be divided into two elemental procedures. The first procedure involves heating the entire printed circuit board to a high temperature to melt the solder flux or paste and using a "pick-and-place" device (population automated machines) to remove the electronic components. The pick-and-place device is a type of robotic machine used to place on or remove electronic components from a printed circuit board. Such a procedure is described, for example, in JP 2601225. Heating the printed circuit board to a high temperature can be done by various sources, including, but not limited to, a laser. The disadvantage is that the removal requires a high temperature to which the printed circuit board and the electronic components on the board must be heated, sometimes resulting in the destruction of selected electronic components or affecting their function or parameters, which is closely related to the high energy consumption of the entire operation. Furthermore, it may happen that adjacent pins of more complex electronic components may be soldered, or even unwanted electronic components may be released too.

An alternative to this procedure of removing electronic components from a printed circuit board is a method where the electronic components are removed by melting low melting temperature alloys and then dropping the melted electronic components from the board using vibration and rocking, as described in CN 106964629. The disadvantage of this solution is that it uses additional vibration devices, making the whole removal procedure more expensive.

The second procedure of printed circuit boards disassembling for subsequent recycling of electronic components is to use chemical solder etching agents or solder paste, thereby removing the electronic components from the base plate surface. This procedure is generally carried out by immersing the entire printed circuit board into the chemical agent solution and transferring the electronic components into the chemical agent solution. Such a procedure is described, for example, in US 5035749, where a chemical agent is used to remove a layer of tin, tin alloy or lead from a printed circuit board using two different agents in two steps without damaging the substrate. First, the tin or lead alloy layer is selectively removed by an agent having a relatively mild oxidizing effect, then the intermetallic layer consisting of tin and copper is removed by a second agent having a stronger oxidizing effect. Ahmet Deniz Bas, Haci Deveci, Ersin Y. Yazici, Treatment of manufacturing scrap TV boards by nitric acid leaching, Separation and Purification Technology, Volume 130, 10 June 2014, Pages 151-159, describe the removal or recovery of valuable metals such as copper and silver from television printed circuit boards by leaching in nitric acid. The disadvantages of these solutions consist mainly in that the application thereof in practice is hampered by possible damage to other components, contacts and entire housings and surfaces of the electronic components.

Further relevant background art is disclosed in US 2009/184407 A1, US 2016/095230 A1, US 2014/021400 A1 and US 2018/168032 A1.

Therefore, the invention aims to provide a method for selectively removing electronic components from printed circuit boards for subsequent recycling thereof, which would eliminate the above deficiencies and would selectively and automatically remove selected electronic components from a printed circuit board without the need to use high operating temperatures or the need to immerse the entire printed circuit board in a chemical or etching agent solution; therefore, such a method, which would be energy-efficient and which would allow controlled and precise dispensing of the etching agent to individual electronic components on the printed circuit board, thus avoiding excessive consumption of the etching agent. In addition, the invention aims to provide a device for carrying out this method. At the same time, the invention aims to provide a method and device that would allow solder paste from printed circuit boards to be recycled, or to recover selected elements of solder paste for further usage.

### Summary of the Invention

The set task is solved by a method of selectively removing electronic components from printed circuit boards according to the present invention. The innovation subject is a technology for a low-energy and automated approach to removing electronic components from old, partially damaged or discarded printed circuit boards in order to use partial electronic components in subsequent applications in a mode of secondary use thereof. In this method, an etching agent is applied to the soldered joint of an electronic component with a printed circuit board containing solder paste.

The summary of the invention consists in that the etching agent is used as an etching paste being applied to the printed circuit board in a precise, local and selective manner by printing the etching paste print layer targeted to specific locations, i.e., to specific areas of soldered joints of selected electronic components which are arranged on the printed circuit board, thereby releasing the selected electronic component from the printed circuit board. Following the application and action of the etching paste, most of the solder flux, with which the electronic component has been attached to the printed circuit board, is locally etched away, and the undamaged electronic component is subsequently released from the printed circuit board. The proposed method can be applied in recycling procedures, where undamaged electronic components are recovered from the printed circuit board, being, after inspection, sorted, and they can be offered on the aftermarket. In addition, all electronic components as well as only selected electronic components from specific locations on the printed circuit board can be removed, leaving the remaining electronic components on the printed circuit board. They will only be removed if they are required to be used.

In an advantageous embodiment, the selective printing of the etching paste print layer produces a reaction product containing metal ions of the solder paste, which is mechanically removed from the printed circuit board and further recycled. Mechanical removal of the reaction product is preferably accomplished by flushing with a stream of liquid followed by the suction thereof.

The etching reaction product can be extracted using a vacuum nozzle, where the etched area can be cleaned afterwards by means of a stream of liquid, typically water, from the pressurized nozzle. The print circuit board may also be given a full surface rinse, but only so that the rinse does not destroy the rest of the printed circuit board or parts thereof. The rinse liquid can be suitably collected and isolated for subsequent recycling of the elements contained in the solder paste. Therefore, a further benefit of this method is the recovery of relatively pure elements such as tin Sn, lead Pb, silver Ag, gold Au, and copper Cu in the form of a solution of salts thereof, which are formed during removal and which can then be isolated in a suitable manner through suitable anions (sulfides, sulfates, carbonates, etc.), or with the help of suitable solvents, or metal ions can be isolated through suitable ion exchangers.

The etching paste is printed in a convenient arrangement using microdispensing or inject printing technologies. Printing technologies enable precise and accurate semi-contact or noncontact application to the required locations on the printed circuit board, so it is a highly efficient method of applying etching paste.

In a preferred embodiment, the etching paste is used from the group consisting of: an acid having strong oxidizing effects, a salt containing Fe³⁺, Ni²⁺, Cu²⁺, an organic acid, a surface tension modifying additive (surfactant), a viscosity modifying additive, or a combination thereof.

The chemical reaction of the etching paste itself can be affected by the composition, and the reaction rate can also be affected by external factors, such as when the printed circuit board or the etching paste is preferably heated before printing the etching paste.

In one preferred embodiment, the printed circuit board is placed in a heated space under a suitable atmosphere, preferably a chamber of a temperature ranging from 30 to 70 °C and a relative humidity ranging from 60 to 100%.

In another preferred embodiment, the etching paste is heated after printing by a laser with a suitable wavelength absorbed by the etching paste or by induction if the etching paste contains magnetic particles. Therefore, the chemical reaction of the etching paste itself can be influenced not only by the composition, but the reaction rate can also be affected by external factors. E.g., by heating-by placing the printed circuit board in a heated space under a suitable atmosphere, e.g., with high relative humidity, by heating the etching paste with a laser beam of a suitable wavelength absorbed by the etching paste, or by induction if the paste contains magnetic particles.

The invention also provides a device for selectively removing electronic components from printed circuit boards in the method described above. The summary of the invention consists in that it includes a control unit having a data storage device where a digital map of electronic components on a printed circuit board to be recycled is stored, further comprising a software module installed on said data storage to identify soldered joint areas of selected electronic components on the printed circuit board, further comprising a printing device to form a printing layer of etching paste targeted to the soldered joint areas of the selected electronic components on the printed circuit board, and provided with a control system and connected to the control unit, and further comprising a removal device to remove loose and intact electronic components from the printed circuit board. The printing device is connected to a control unit that identifies the type of base printed circuit board for which the control unit, usually a control computer, has the exact coordinates of the individual electronic components, the contacts thereof. Based on this data, the etching paste is then applied to the specific pins or soldered joints to etch away the solder paste, thereby releasing the affected electronic component from the printed circuit board. The etching paste can be specifically formulated according to the type of printed circuit board or solder paste applied thereto. The etching process also recovers selected chemical elements from the solder pastes that can be reused in their subsequent application. After cleaning the printed circuit board, the electronic components are then removed from the printed circuit board using another collaborative robot or pick-and-place device and placed in a binder for the electronic components to be separated or for a secondary procedure of cleaning, inspection, etc.

In one preferred embodiment, the printing device comprises a printing robotic arm with a printing head; typically, it is a collaborative robot with a microdispensing printing head or InkJet printing head.

In another preferred embodiment, the printing device comprises a multi-axis positioning device with a printing head; typically, it is a microdispensing printing head or InkJet printing head, which is manipulated with a motorized X, Y, Z feed. This ensures the etching paste can be applied to a planar 2D printed circuit board, but also to special types of printed circuit board having a 3D concave or convex shape.

In a preferred arrangement, the removal device includes a removal robotic arm with a gripper (clipper), or the electronic component may be removed using tweezers or other gripping device.

In a preferred embodiment, the device further comprises a heating device selected from the group consisting of: induction, laser. Increasing the temperature of the etching paste will result in faster release of the electronic component from the printed circuit board.

In particular, the advantages of the method for selectively removing electronic components from printed circuit boards for subsequent recycling and the device for carrying out the said method consist in that it selectively and automatically removes selected electronic components from the printed circuit board without the need to use high operating temperatures or the need to immerse the entire printed circuit board in a chemical or etching solution; therefore, it is an energy-efficient method allowing controlled and precise dispensing of the etching agent to individual electronic components on the printed circuit board. Therefore, there is no excessive consumption of the etching agent. In addition, this method also makes it possible to recycle solder pastes from the printed circuit boards, or to recover selected elements of solder pastes for further usage thereof.

### Brief Description of the Drawings

The said invention will be explained in more detail in the following illustrations, wherein:
- Fig. 1: shows a view of a printing device with a multi-axis positioning device;
- Fig. 2: shows a view of a device for selective removal of electronic components from a printed circuit board.

### Examples of Invention Embodiments

### Example 1

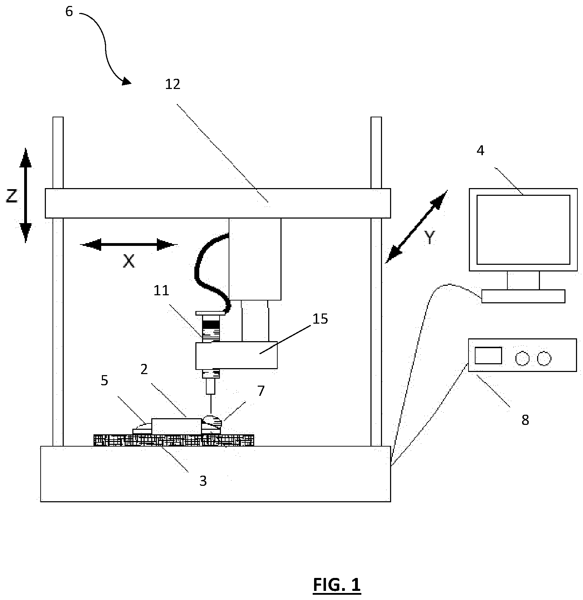

The model printed circuit board 3 -Adruino Pro Mini was used. The etching paste 7 composed of nitric acid, water, Fe³⁺ salt, surface tension modifying additive based on a nonionic surfactant, and a viscosity modifying additive based on a cellulose derivative was used as the etching agent. The viscosity of the resulting etching paste 7 was 6.0 Pa.s. The etching paste 7 was put into the printing device 6 shown in Fig. 1, namely into the dispenser container, and, at a pressure of 200 kPa, approximately 50 µL of the etching paste 7 was printed into the soldered joint 5 area of the electronic components 2 of the selected resistors on the printed circuit board 3 through the printing head 11 needle having a diameter of 160 µm. The printing device 6, or the printing head 11, is provided with a dispenser control system 8, which is connected to the control unit 4. An X, Y, Z multi-axis positioning device 12 controlled by a G-code from the control unit 4 was used to manipulate the printing head 11 of the dispenser. In the software module installed on the data storage device in the control unit 4, the exact coordinates of the electronic components 2 on the printed circuit board 3 for dispensing the etching paste 7 were entered, based on which the needle tip of the printing head 11 was precisely positioned, and, subsequently, the dispensing of the etching paste 7 was always carried out. The etching paste 7 was then allowed to act for 1000 s, and then the electronic component 2 was removed from the printed circuit board 3 using a tweezer-based removal device 9.

### Example 2

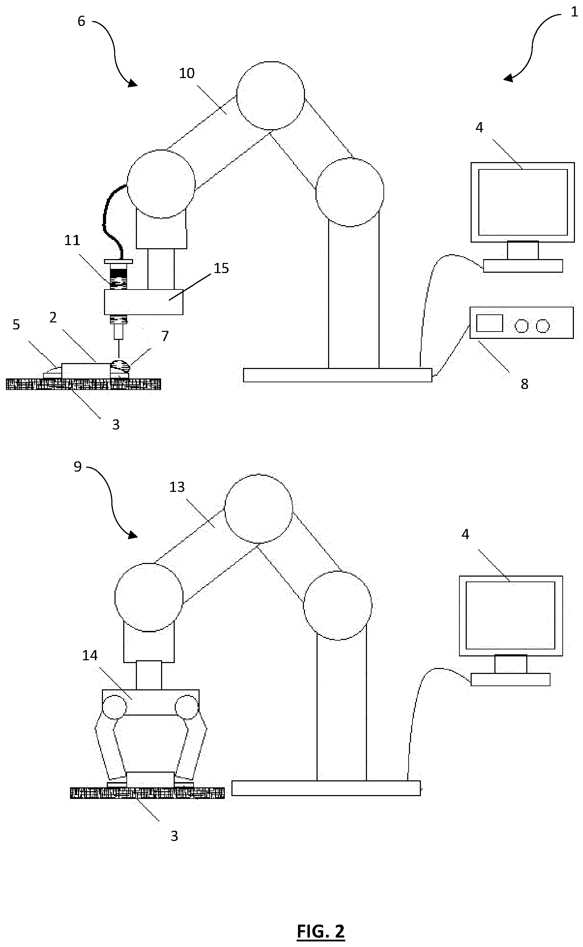

The model printed circuit board 3 - Raspberry Pi Pico was used. The etching paste 7 composed of nitric acid, hydrochloric acid, organic acid, Fe³⁺ salt, surface tension modifying additive based on a nonionic surfactant, and a viscosity modifying additive based on a cellulose derivative was used as the etching paste 7. The viscosity of the resulting etching paste 7 was 7.3 Pa.s. The etching paste 7 was fed into the printing device 6 shown in Fig. 2, specifically into the dispenser container with the printing robotic arm 10 shown in Fig. 2, and, at a pressure of 150 kPa, approximately 40 µL of the etching paste 7 was dispensed into the soldered joint 5 area of the selected resistors on the printed circuit board 3 through the 120-µm diameter needle of the printing head 11. The printing robotic arm 10, particularly a 5-axis collaborative robot, was used to manipulate the printing head 11 of the dispenser, wherein the arm movement was programmed via a software module installed on a data storage device in the control unit 4. Therein, the exact coordinates for the dosing of the etching paste 7 were entered, on the basis of which the needle tip of the printing head 11 was precisely positioned, and, subsequently, the dosing of the etching paste 7 was always carried out. Subsequently, the etching paste 7 was allowed to act for 1100 s, and then the electronic component 2 was removed from the printed circuit board 3 using the automatic removal device 9 shown in Fig. 2, which has the removal robotic arm 13 with a clipper/gripper 14 the operation coordinates of which were programmed as well. The entire device 1 for selectively removing electronic components 2 from the printed circuit board 3 is shown in Fig. 2.

### Example 3

As in the Example 2, except that the printed circuit board 3 with the electronic components 2 was placed in a chamber heated to 60 °C with a relative humidity close to RH 100% for 400 seconds. Subsequently, the printed circuit board 3 was removed from the box and selected electronic components 2 - MCU (micro controller unit) were removed with tweezers.

### Example 4

As in the Example 1, except that etching paste 7 based on nitric acid, chromosulfuric acid, organic acid, Ni²⁺, Cu²⁺, Fe³⁺ salts, surface tension modifying additive based on a nonionic surfactant, and a viscosity modifying additive based on a cellulose derivative was used. The area of the dosed etching pastes 7 was selectively heated with an NIR laser for 300 s. Subsequently, the electronic components 2 - resistors were removed with tweezers. It was followed distilled water dosing with a dispenser and then the water was sucked out through a vacuum dispensing head. This procedure was repeated twice and the resulting liquid was collected in a waste container.

### Example 5

As in the Example 2, the given etching paste 7 was used, and the removal device 9 fitted with the removal robotic arm 13 with the clipper/gripper 14, particularly a 5-axis collaborative robot, was used to dispense and remove the electronic components 2. Iron particles were embedded into the etching paste 7, coated with a protective polymer to prevent corrosion thereof. After dispensing the etching paste 7 onto the soldered joint 5 areas, the printed circuit board 3 was placed in the heating chamber (T = 60 °C and RH 95%) and the induction heating was turned on. The iron particles in the etching paste 7 caused local heating of the etching paste 7 and an increase in the etching efficiency thereof. After 250 s, the printed circuit board 3 was taken out and the selected electronic components 2 were removed with tweezers.

### Example 6

As in the Example 5, except that the electronic components 2 were removed using the removal device 9 based on a collaborative robot with the gripper 14. Local cleaning of the printed circuit board 3 was also performed, as in the Example 4.

### Example 7

As in the Example 1, except that an InkJet printing head 11 and a print formulation without a viscosity-increase additive were used for printing. The InkJet printing head 11 enabled noncontact printing from a distance of 2 cm from the printed circuit board 3.

### Example 8

The Sn salt solution was precipitated from the collected solution by a reaction with (NH₄)₂S to form sulfide, which was subsequently filtered on filter paper and washed.

### Industrial Applicability

A method of selectively removing electronic components from printed circuit boards for subsequent recycling thereof, and device for carrying out the method according to the present invention, can be applied in recycling procedures whereby the electronic components are obtained from the printed circuit boards in this way, being, after inspection, sorted, and they can be offered on the aftermarket. Another benefit of this method is the recovery of relatively pure elements such as Sn, Pb, Ag, and Cu in the form of a solution of the salts thereof, wherein these salts are formed during removal, and they can then be suitably isolated in the form of precipitates of suitable chemical compounds.

### Reference Signs List

- 1: Device
- 2: Electronic component
- 3: Printed circuit board
- 4: Control unit
- 5: Soldered joint
- 6: Printing device
- 7: Etching paste
- 8: Dispenser control system
- 9: Removal device
- 10: Printing robotic arm
- 11: Printing head
- 12: Multi-axis positioning device
- 13: Removal robotic arm
- 14: Clipper
- 15: Container

## Claims

1. The method for selectively removing electronic components (2) from printed circuit boards (3), wherein an etching agent is applied to the soldered joint (5) of the electronic component (2) with the printed circuit board (3) containing a solder paste, **characterized in that** the etching paste (7) is used as the etching agent, which is selectively applied to the printed circuit board (3) by printing a layer of the etching paste (7) targeted to the soldered joint (5) areas of the selected electronic components (2) on the printed circuit board (3), thereby releasing the selected electronic component (2) from the printed circuit board (3).

2. The method according to claim 1, **characterized in that** the selective printing of the etching paste (7) print layer produces a reaction product containing metal ions of the solder paste, which is mechanically removed from the printed circuit board (3) and further recycled.

3. The method according to claim 2 **characterized in that** the mechanical removal of the reaction product is accomplished by flushing with a stream of liquid followed by the suction thereof.

4. The method according to any of claims 1 to 3 **characterized in that** the etching paste (7) is printed by microdispensing printing technique or InkJet printing.

5. The method according to any one of claims 1 to 4, **characterized in that** the etching paste (7) is used from the group consisting of: an acid having strong oxidizing effects, a salt containing Fe³⁺, Ni²⁺, Cu²⁺, an organic acid, a surface tension modifying additive, a viscosity modifying additive, or a combination thereof.

6. The method according to any one of claims 1 to 5 **characterized in that** the printed circuit board (3) or the etching paste (7) is heated before printing the etching paste (7).

7. The method according to claim 6, **characterized in that** the printed circuit board (3) with the applied etching paste (7) is placed in a chamber of a temperature ranging from 30 to 70 °C and a relative humidity ranging from 60 to 100%.

8. The method according to claim 6 **characterized in that** the etching paste (7) is heated by laser or induction after printing.

9. The device (1) for selectively removing electronic components (2) from printed circuit boards (3) using the method according to any one of claims 1 to 8, **characterized in that** it comprises the control unit (4) with a data storage where a digital map of the electronic components (2) on the printed circuit board (3) to be recycled is stored, further comprising a software module installed on this data storage to identify soldered joint (5) areas of selected electronic components (2) on the printed circuit board (3), further comprising the printing device (6) to form a printing layer of etching paste (7) targeted to the soldered joint (5) areas of the selected electronic components (2) on the printed circuit board (3), which is connected with the control unit (4), and further comprising the removal device (9) to remove the loose electronic component (2) from the printed circuit board (3).

10. The device (1) according to claim 9 **characterized in that** the printing device (6) comprises the printing robotic arm (10) having the printing head (11).

11. The device (1) according to claim 9 **characterized in that** the printing device (6) comprises multi-axis positioning device (12) having the printing head (11).

12. The device (1) according to any of claims 9 to 11 **characterized in that** the removal device (9) comprises the removal robotic arm (13) having the gripper (clipper) (14).

13. The device (1) according to any of claims 9 to 12 **characterized in that** it further comprises a heating device selected from the group consisting of: induction, laser.

## Patentansprüche

1. Verfahren zur selektiven Demontage von elektronischen Bauteilen (2) von Leiterplatten (3), bei dem ein Ätzmittel auf die Lötverbindung (5) des elektronischen Bauteils (2) mit der Leiterplatte (3), die Lötpaste enthält, aufgetragen wird, **dadurch gekennzeichnet, dass** als Ätzmittel eine Ätzpaste (7) verwendet wird, die selektiv auf die Leiterplatte (3) aufgebracht wird, indem eine Druckschicht der Ätzpaste (7) gezielt in die Bereiche der Lötverbindungen (5) ausgewählter elektronischer Bauteile (2) auf die Leiterplatte (3) aufgedruckt wird, wodurch das ausgewählte elektronische Bauteil (2) von der Leiterplatte (3) gelöst wird.

2. Verfahren nach Anspruch 1, **dadurch gekennzeichnet, dass** durch das selektive Aufdrucken der Druckschicht der Ätzpaste (7) ein Reaktionsprodukt entsteht, das Metallionen der Lötpaste enthält, welches mechanisch von der Leiterplatte (3) entfernt und weiter recycelt wird.

3. Verfahren nach Anspruch 2, **dadurch gekennzeichnet, dass** die mechanische Entfernung des Reaktionsprodukts durch Spülen mit einem Flüssigkeitsstrom und anschließendes Absaugen erfolgt.

4. Verfahren nach einem der Ansprüche 1 bis 3, **dadurch gekennzeichnet, dass** die Ätzpaste (7) durch Mikrodispensing oder Inkjet-Druck aufgedruckt wird.

5. Verfahren nach einem der Ansprüche 1 bis 4, **dadurch gekennzeichnet, dass** die Ätzpaste (7) aus der Gruppe verwendet wird: Säure mit starker Oxidationswirkung, Salz enthaltend Fe³⁺, Ni²⁺, Cu²⁺, organische Säure, Additiv zur Einstellung der Oberflächenspannung, Additiv zur Einstellung der Viskosität oder deren Kombination.

6. Verfahren nach einem der Ansprüche 1 bis 5, **dadurch gekennzeichnet, dass** die Leiterplatte (3) oder die Ätzpaste (7) vor dem Aufdrucken der Ätzpaste (7) erwärmt wird.

7. Verfahren nach Anspruch 6, **dadurch gekennzeichnet, dass** die Leiterplatte (3) mit der aufgetragenen Ätzpaste (7) in eine Kammer mit einer Temperatur im Bereich von 30 bis 70 °C und einer relativen Luftfeuchtigkeit im Bereich von 60 bis 100 % eingebracht wird.

8. Verfahren nach Anspruch 6, **dadurch gekennzeichnet, dass** die Ätzpaste (7) nach dem Aufdrucken durch Laser oder Induktion erwärmt wird.

9. Vorrichtung (1) zur selektiven Demontage von elektronischen Bauteilen (2) von Leiterplatten (3) nach einem der Ansprüche 1 bis 8, **dadurch gekennzeichnet , dass** sie eine Steuereinheit (4) mit einem Datenspeicher umfasst, auf dem eine digitale Karte der elektronischen Bauteile (2) auf der zu recycelnden Leiterplatte (3) gespeichert ist, ferner ein auf diesem Speicher installiertes Softwaremodul zur Identifizierung der Bereiche der Lötverbindungen (5) ausgewählter elektronischer Bauteile (2) auf der Leiterplatte (3), ferner ein Druckgerät (6) zum Erzeugen einer Druckschicht der Ätzpaste (7) gezielt in die Bereiche der Lötverbindungen (5) ausgewählter elektronischer Bauteile (2) auf die Leiterplatte (3), das mit der Steuereinheit (4) verbunden ist, und ferner eine Entnahmevorrichtung (9) zur Entnahme des gelösten elektronischen Bauteils (2) von der Leiterplatte (3) umfasst.

10. Vorrichtung (1) nach Anspruch 9, **dadurch gekennzeichnet, dass** das Druckgerät (6) einen Druckroboterarm (10) mit einem Druckkopf (11) umfasst.

11. Vorrichtung (1) nach Anspruch 9, **dadurch gekennzeichnet, dass** das Druckgerät (6) eine mehrachsige Positioniereinrichtung (12) mit einem Druckkopf (11) umfasst.

12. Vorrichtung (1) nach einem der Ansprüche 9 bis 11, **dadurch gekennzeichnet, dass** die Entnahmevorrichtung (9) einen Entnahmeroboterarm (13) mit einem Greifer (Clipper) (14) umfasst.

13. Vorrichtung (1) nach einem der Ansprüche 9 bis 12, **dadurch gekennzeichnet, dass** sie ferner eine Heizeinrichtung umfasst, die aus der Gruppe ausgewählt ist: Induktion, Laser.

## Revendications

1. Procédé de démontage sélectif de composants électroniques (2) de cartes de circuits imprimés (3) dans lequel un agent de gravure est appliqué sur le joint soudé (5) du composant électronique (2) avec une carte de circuits imprimés (3) contenant de la pâte à braser, **caractérisé en ce qu'**une pâte de gravure (7) est utilisée comme agent de gravure, qui est déposée sélectivement sur la carte de circuits imprimés (3) en imprimant une couche d'impression de la pâte de gravure (7) de manière ciblée dans les zones des joints soudés (5) des composants électroniques (2) sélectionnés sur la carte de circuits imprimés (3), détachant ainsi le composant électronique (2) sélectionné de la carte de circuits imprimés (3).

2. Procédé selon la revendication 1, **caractérisé en ce que** l'impression sélective de la couche d'impression de la pâte de gravure (7) produit un produit de réaction contenant des ions métalliques de la pâte à braser, qui est éliminé mécaniquement de la carte de circuits imprimés (3) et recyclé.

3. Procédé selon la revendication 2, **caractérisée en ce que** l'élimination mécanique du produit de réaction est réalisée par un rinçage au moyen d'un flux de liquide, suivi de son aspiration.

4. Procédé selon l'une des revendications 1 à 3, **caractérisé en ce que** la pâte de gravure (7) est imprimée par microdistribution ou par impression à jet d'encre.

5. Procédé selon l'une des revendications 1 à 4, **caractérisé en ce que** la pâte de gravure (7) est choisie dans le groupe : acide à fort pouvoir oxydant, sel contenant Fe³⁺, Ni²⁺, Cu²⁺, acide organique, additif modifiant la tension de surface, additif modifiant la viscosité ou une combinaison de ceux-ci.

6. Procédé selon l'une des revendications 1 à 5, **caractérisé en ce que** la carte de circuits imprimés (3) ou la pâte de gravure (7) est chauffée avant l'impression de la pâte de gravure (7).

7. Procédé selon la revendication 6, **caractérisée en ce que** la carte de circuits imprimés (3) avec la pâte de gravure déposée (7) est placée dans une chambre dont la température est comprise entre 30 et 70 °C et l'humidité relative entre 60 et 100 %.

8. Procédé selon la revendication 6, **caractérisée en ce que** la pâte de gravure (7) est chauffée par laser ou induction après l'impression.

9. Dispositif (1) de démontage sélectif des composants électroniques (2) de cartes de circuits imprimés (3) selon le procédé décrit dans l'une des revendications 1 à 8, c a**ractérisé en ce** qu'il comprend une unité de commande (4) avec stockage de données, sur lequel une carte numérique des composants électroniques (2) présents sur la carte de circuits imprimés (3) est stockée et recyclée, comprenant en outre un module logiciel installé sur ce stockage pour identifier les zones de joints soudés (5) des composants électroniques (2) sélectionnés sur la carte de circuits imprimés (3), comprenant en outre un dispositif d'impression (6) pour déposer une couche d'impression de pâte de gravure (7) de manière ciblée sur les zones de joints soudés (5) des composants électroniques (2) sélectionnés sur la carte de circuits imprimés (3), qui est relié à l'unité de commande (4), et comprenant en outre un dispositif de retrait (9) pour retirer un composant électronique (2) détaché de la carte de circuits imprimés (3).

10. Dispositif (1) selon la revendication 9, **caractérisé en ce que** le dispositif d'impression (6) comprend un bras robotique d'impression (10) avec une tête d'impression (11).

11. Dispositif (1) selon la revendication 9, **caractérisé en ce que** le dispositif d'impression (6) comprend un dispositif de positionnement multiaxial (12) avec une tête d'impression (11).

12. Dispositif (1) selon l'une des revendications 9 à 11, **caractérisé en ce que** le dispositif de retrait (9) comprend un bras robotisé de retrait (13) avec un préhenseur (clipper) (14).

13. Dispositif (1) selon l'une des revendications 9 à 12, **caractérisé en ce qu'**il comprend en outre un dispositif de chauffage choisi dans le groupe : induction, laser.
